# EUROPÄISCHE PATENTSCHRIFT

(11) **EP 2 156 717 B1**
(45) Veröffentlichungstag und Bekanntmachung des Hinweises auf die Patenterteilung: **25.09.2019**
(21) Anmeldenummer: 08715991.9
(22) Anmeldetag: 22.02.2008
(51) Int. Cl.: H05K 5/00, H05K 5/06, H02K 5/136

(54) **GEHÄUSE FÜR ELEKTRISCHE BETRIEBSMITTEL**
HOUSING FOR ELECTRICAL OPERATING MEANS
BOÎTIER POUR MATÉRIEL ÉLECTRIQUE

(30) Priorität: 25.05.2007 DE 102007024421
(43) Veröffentlichungstag der Anmeldung: 24.02.2010
(73) Patentinhaber: Cooper Crouse-Hinds GmbH, 59494 Soest (DE)
(72) Erfinder: SCHWARZ, Gerhard, 69436 Schönbrunn (DE); NAUMANN, Reiner, 68239 Mannheim (DE)
(74) Vertreter: Eaton IP Group EMEA
(86) Internationale Anmeldenummer: PCT/EP2008/001440
(87) Internationale Veröffentlichungsnummer: WO 2008/145205

(56) Entgegenhaltungen:
- EP-A- 0 777 407
- DE-A1- 19 826 911
- US-A1- 2005 029 881
- US-A1- 2007 159 018
- US-B1- 6 392 322

## Beschreibung

Die Erfindung betrifft ein Gehäuse für elektrische Betriebsmittel, wie Leuchte, Steckeinrichtung, Messinstrument, Schaltwerke, Verteiler oder dergleichen. Das Gehäuse weist wenigstens ein erstes und ein zweites Gehäuseteil auf. Diese sind miteinander explosionsgeschützt zusammensetzbar, wobei jedes Gehäuseteil eine Fügefläche aufweist, die bei zusammengesetzten Gehäuseteilen miteinander unter Bildung eines durchschlagsicheren Spaltes in Anlage sind.

Solche Gehäuseteile werden für die verschiedensten elektrischen Betriebsmittel in explosionsgefährdeten Bereichen eingesetzt. Um Fügeflächen zu realisieren, weist der zünddurchschlagsichere Spalt in der Regel eine bestimmte Länge und eine bestimmte Spaltbreite auf. Entsprechende Anforderungen an den Explosionsschutz ergeben sich beispielsweise aus der Ex-Richtlinie 94/9/EG. Die elektrischen Betriebsmittel werden dabei in Gerätegruppen I und II eingeteilt. Die Gerätegruppe II umfasst alle elektrischen Betriebsmittel für explosionsgefährdete Bereiche, außer schlagwettergefährdete Grubenbauten. Die Gerätegruppe II unterteilt sich in A, B und C, wobei die Betriebsmittel nach Gerätegruppe C in am leichtesten zu entzündenden Atmosphären angeordnet sind und daher auch zur Verwendung für Gerätegruppen II A und B geeignet sind.

Für elektrische Betriebsmittel in Gehäusen mit eckigem Querschnitt werden insbesondere flache Fügeflächen verwendet, die bei zusammengesetzten Gehäuseteilen mit ihren flachen Seiten aneinander liegen. Zwischen diesen flachen Seiten ist der entsprechende zünddurchschlagsichere Spalt gebildet. Die Befestigung der Gehäuseteile miteinander kann im Bereich der Fügeflächen oder auch an anderer Stelle erfolgen.

Eckige Gehäuse haben den Vorteil, dass die in ihnen angeordneten elektrischen Betriebsmittel in der Regel besser erreichbar sind als beispielsweise bei Gehäusen mit kreisförmigem Querschnitt. Bei solchen Gehäusen mit kreisförmigem Querschnitt sind die entsprechenden Fügeflächen in der Regel als in Längsrichtung der Gehäuseteile vorlaufende Gewindeflächen ausgebildet, so dass die beiden Gehäuseteile miteinander mittels dieser Gewindeflächen verschraubbar sind. In diesem Fall wird der durchschlagsichere Spalt zwischen den Gewindeflächen gebildet.

Der Erfindung liegt die Aufgabe zu Grunde, eine neuartige Strukturierung von Fügeflächen bereitzustellen, mittels der unabhängig von der Querschnittsform der Gehäuseteile ein entsprechender durchschlagsicherer Spalt in einfacher konstruktiver Weise gebildet ist und im Wesentlichen die Vorteile der beiden oben genannten Fügeflächen sowie Gehäuse miteinander vereint werden. Das erfindungsgemäße Gehäuse ist insbesondere auch für Gerätegruppen II C einsetzbar.

Diese Aufgabe wird durch ein Gehäuse mit den Merkmalen des Patentanspruchs 1 gelöst.

Erfindungsgemäß erfolgt ein Ineinandergreifen dieser Oberflächenprofilierungen einfach beim Zusammensetzen der beiden Gehäuseteile, wobei dies im Wesentlichen den oben beschriebenen, aneinander anliegenden flachen Fügeflächen entspricht. Allerdings ergibt sich durch die erfindungsgemäße Oberflächenprofilierung der Fügeflächen, dass diese Fügeflächen mit geringeren Abmessungen ausgebildet werden können, ohne dass dadurch der zünddurchschlagsichere Spalt verkürzt wird, da sich dessen Länge durch die entsprechende Oberflächenprofilierung auch bei Fügeflächen mit geringerem Ausmaß erhöht. Da die entsprechenden Oberflächenprofilierungen allerdings nicht zum Verschrauben dienen, sondern einfach durch Kontakt der entsprechenden Fügeflächen miteinander in Eingriff geraten, ist beispielsweise kein Verdrehen der Gehäuseteile relativ zueinander notwendig, so dass auch keine Einschränkungen hinsichtlich des Querschnitts der Gehäuseteile gelten, wie beispielsweise kreisförmige Querschnitte.

Es besteht die Möglichkeit, dass die entsprechenden Fügeflächen auch geneigt, d.h. unter einem Winkel von ungleich 90°, zu den übrigen Gehäuseteilen angeordnet sind. In diesem Zusammenhang ist allerdings von Vorteil, wenn die Neigungen der entsprechenden Fügeflächen der Gehäuseteile komplementär zueinander sind, so dass beispielsweise bei einer Neigung von 120° relativ zur Längsrichtung des einen Gehäuseteils die Neigung der Fügefläche des anderen Gehäuseteils 60° in entsprechender Richtung beträgt.

Zur Vereinfachung der Herstellung der entsprechenden Fügeflächen ist allerdings eine im Wesentlichen senkrechte Ausrichtung zu den übrigen Gehäuseteilen günstiger.

Es besteht die Möglichkeit, dass die entsprechende Oberflächenprofilierung sich beispielsweise nur zu einem Teil in Richtung der Fügeflächen erstreckt, wobei die Fügeflächen als Teil einer im Wesentlichen radial nach außen vom Gehäuseteil abstehenden Flanschfläche ausgebildet sein können. Diese Flanschfläche kann außerhalb der Oberflächenprofilierung auch flacher Bereiche oder anders strukturierte Bereiche aufweisen.

Um umlaufend um das entsprechende Gehäuseteil und ohne weitere Mittel einen entsprechenden Explosionsschutz zu ermöglichen, kann die Fügefläche umlaufend um das Gehäuseteil mit entsprechender Oberflächenprofilierung ausgebildet sein.

Wie bereits im Wesentlichen angemerkt, kann erfindungsgemäß das Gehäuseteil einen kreisförmigen oder eckigen Querschnitt aufweisen. Bevorzugte eckige Querschnitte sind viereckige und dabei quadratische oder rechteckige Querschnitte.

Hinsichtlich der Fügeflächen und der Oberflächenprofilierung sind grundsätzliche keine Einschränkungen bezüglich des entsprechenden Materials gegeben, so dass die für explosionsgeschützte Gehäuse in der Regel verwendeten Materialien möglich sind. Beispielsweise kann das Gehäuseteil zumindest im Bereich der Fügefläche aus einem Metall, insbesondere Leichtmetall hergestellt sein. Ein solches Metall ist Aluminium, Messing oder auch Stahlblech. Es besteht natürlich die Möglichkeit, dass nicht nur die entsprechende Fügefläche mit Oberflächenprofilierung, sondern das gesamte Gehäuseteil aus diesem Material hergestellt ist.

Eine weitere Möglichkeit ist die Herstellung des Gehäuseteils zumindest im Bereich der Fügefläche aus einem Kunststoffmaterial. Beispiele für solche Kunststoffmaterialien sind Thermoplaste und insbesondere Polyamid, Polycarbonat und auch Polyester. Auch hier besteht die Möglichkeit, das gesamte Gehäuseteil aus diesem Material herzustellen.

Es ist weiterhin denkbar, dass erstes und zweites Gehäuseteil zumindest im Bereich der Fügeflächen aus unterschiedlichen Materialien hergestellt sind.

Bei einem Gehäuseteil aus Metall kann es günstig sein, wenn das Gehäuseteil wenigstens eine Beschichtung aus insbesondere einem Kunststoff aufweist. Ein Beispiel für eine solche Beschichtung aus einem Kunststoffmaterial ist Polyester, PTFE (Polytetrafluorethylen) oder auch eine Eloxierung des Metalls.

Um das gesamte Gehäuseteil einfach herstellen zu können, kann dieses mit Fügefläche aus einem Gussteil hergestellt sein.

In diesem Zusammenhang besteht weiterhin die Möglichkeit, dass die Oberflächenprofilie- rung gleichzeitig beim Gießen des Gehäuseteils herstellbar ist. Ein solches Gießen kann beispielsweise ein Druckgießen oder auch ein Spritzen sein.

Es besteht weiterhin die Möglichkeit, dass die Oberflächenprofilierung durch insbesondere spanende Bearbeitung der Fügeflächen nach bereits Herstellen des entsprechenden Gehäuseteils mit Fügefläche nachträglich hergestellt wird.

Es wurde bereits darauf hingewiesen, dass die Oberflächenprofilierung sich in Profilrichtung um das Gehäuseteil erstrecken kann. Dabei kann sich die Oberflächenprofilierung in Profilrichtung aus im Wesentlichen kreisförmigen Einzelprofilen zusammensetzen. Bei solchen kreisförmigen Einzelprofilen ist die gesamte Oberflächenprofilierung der entsprechenden Fügeflächen durch konzentrisch zueinander angeordnete Einzelprofile gebildet.

Sowohl in Profilrichtung als auch senkrecht zu dieser kann die Oberflächenprofilierung mit gleicher Profiltiefe oder Profilhöhe ausgebildet sein. D.h., dass beispielsweise in Profilrichtung ein Einzelprofil eine konstante Profiltiefe oder Profilhöhe relativ zur übrigen Fügefläche aufweist. Es besteht allerdings ebenfalls die Möglichkeit, dass sich die Profiltiefe oder Profilhöhe in dieser Richtung ändert, wobei eine solche Änderung kontinuierlich oder auch sprunghaft erfolgen kann. Dies gilt analog auch für die Oberflächenprofilierung in Richtung senkrecht zur Profilrichtung. D.h., dass beispielsweise verschiedene, nebeneinander angeordnete Einzelprofile unterschiedliche Profiltiefen oder Profilhöhen aufweisen. Auch eine Kombination der beiden vorangehend genannten Möglichkeiten ist denkbar.

Um die Herstellung der entsprechenden Oberflächenprofilierungen zu vereinfachen und gleichzeitig in günstiger Weise die Spaltabmessung vorgeben zu können, können die beiden ineinander greifenden Oberflächenprofilierungen der Gehäuseteile komplementär zueinander ausgebildet sein.

Um die entsprechenden Gehäuseteile einfach miteinander verbinden zu können, können diese im Bereich der Fügeflächen insbesondere außerhalb der Oberflächenprofilierungen lösbar miteinander verbunden sein. Eine solche Verbindung kann über Schrauben oder dergleichen erfolgen.

Es ist weiterhin denkbar, dass die Oberflächenprofilierung relativ zur übrigen Fügefläche vorstehend oder versenkt ausgebildet ist. Dabei ist es ebenso denkbar, dass die entsprechende Profilspitzen jeweils über die übrige Fügefläche vorstehen, während entsprechende Profilsenken versenkt relativ zur übrigen Fügefläche angeordnet sind. Ebenso ist denkbar, dass die Profilspitzen flächenbündig zur übrigen Fügefläche enden und die Profilsenken in dieser Fügefläche versenkt sind.

Weitere Kombinationen sind möglich.

Im Folgenden wird anhand der in der Zeichnung beigefügten Figuren näher erläutert.

Es zeigen:
- Fig. 1: eine Draufsicht auf ein Gehäuse mit kreisförmigem Querschnitt;
- Fig. 2: eine Draufsicht auf ein Gehäuse mit rechteckigem Querschnitt;
- Fig. 3: ein Schnitt entlang der Linie III-III aus Fig. 1 oder Fig. 2;
- Fig. 4: eine Draufsicht auf ein Gehäuse mit rechteckförmigem Querschnitt gemäß eines Ausführungsbeispiels der Erfindung, und
- Fig. 5: ein Schnitt entlang der Linie V-V aus Fig. 4.

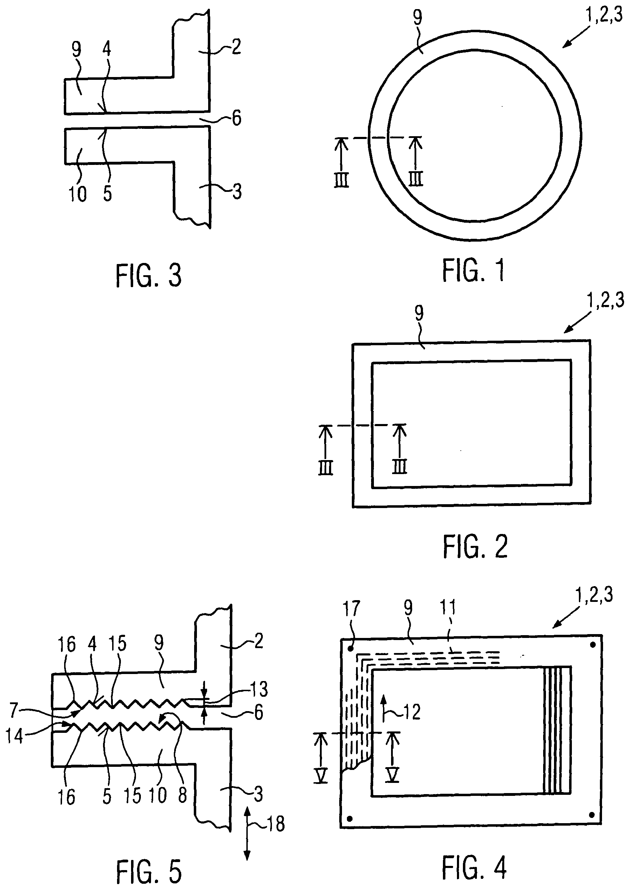

An dieser Stelle sei nochmals darauf hingewiesen, dass der entsprechende Schnitt nach Fig. 5 auch bei Fig. 1, siehe Schnittlinie III-III, vorhanden sein kann. Erfindungsgemäß ist die Oberflächenprofilierung nicht auf eckige oder runde Gehäuse beschränkt.

In Fig. 1 ist eine Draufsicht auf ein Gehäuse 1 aus einem ersten und einem zweiten Gehäuseteil 2, 3 mit kreisförmigem Querschnitt dargestellt. Innerhalb des Gehäuses kann sich ein elektrisches Betriebsmittel befinden, wie eine Leuchte, eine Steckeinrichtung, ein Messinstrument, ein Schaltwerk, ein Verteiler oder dergleichen. Entsprechende Leuchten sind beispielsweise tragbare Leuchten, eine Stableuchte, eine Handleuchte, eine Kopfleuchte, eine Langfeldleuchte oder dergleichen. Weiterhin kann ein solches Gehäuse auch für Abzweigdosen, Leitungseinführungen, Taster, Sicherheitsschalter, Feldverteilung oder dergleichen verwendet werden.

Eine weitere Gehäuseform ist in Fig. 2 dargestellt, wobei sich diese nur im Querschnitt vom Gehäuse nach Fig. 1 unterscheidet. In Fig. 2 weist das Gehäuse einen eckigen und insbesondere rechteckigen Querschnitt auf. Im Bereich von das Gehäuse 1 umgebenden Flanschflächen 9, siehe auch Fig. 3, ist jeweils ein zünd-durchschlagsicherer Spalt 6 gebildet. Die Fig. 3 entspricht einem Schnitt entlang der Linie III-III sowohl aus Fig. 1 als auch Fig. 2.

Bei Fig. 3 sind die beiden Gehäuseteile 2 und 3 mit Abstand zueinander angeordnet, so dass der entsprechende Spalt 6 im Vergleich zu einem Spalt bei miteinander in Anlage befindlichen Flanschflächen 9, 10 erheblich vergrößert dargestellt ist. Der tatsächliche Spalt 6 ist erst gebildet, wenn die entsprechenden Fügeflächen 4, 5 der aufeinander zuweisenden Flanschflächen 9, 10 der Gehäuseteile 2, 3 miteinander in Anlage sind.

Für den Spalt 6 ergibt sich dann eine bestimmte Länge und auch Spaltbreite, die den Erfordernissen für explosionsgeschützte Betriebsmitteln genügen.

In Fig. 4 ist eine Draufsicht auf ein Gehäuse 1 mit Gehäuseteilen 2 und 3 und entsprechenden Flanschflächen 9, 10 analog zu Fig. 3 für ein erfindungsgemäßes Ausführungsbeispiel dargestellt.

Im Bereich der Flanschflächen 9, 10 erstreckt sich eine Oberflächenprofilierung 7, 8 in Profilrichtung 12. Die Oberflächenprofilierungen 7, 8 sind im Bereich der entsprechenden Fügeflächen 4, 5 ausbildet, siehe auch Fig. 5, die einem Schnitt entlang der Linie V-V aus Fig. 4 entspricht.

Es sei nochmals darauf hingewiesen, dass entsprechende Oberflächenprofilierungen 7, 8 auch beim Gehäuse 1 nach Fig. 1 einsetzbar sind, wobei der Schnitt nach Fig. 5 in diesem Fall dem Schnitt der Linie III-III nach Fig. 1 entspräche.

In Fig. 4 ist weiterhin erkennbar, dass bei einem solchen Gehäuse 1 mit rechteckigem Querschnitt die Oberflächenprofilierung 7, 8, siehe auch Fig. 5, sich aus verschiedenen Einzelprofilen sowohl senkrecht zur Längsrichtung 18 als auch in Profilrichtung 12 zusammensetzt. Dabei treffen sich die verschiedenen Einzelprofile in entsprechenden Ecken des Gehäuses 1 und sind dort miteinander verbunden und gehen ineinander über. In Richtung senkrecht zur Längsrichtung 18 der Gehäuseteile sind die entsprechenden Einzelprofile nebeneinander und beispielsweise gleich beabstandet angeordnet. Bei Gehäusen 1 mit kreisförmigem Querschnitt kann eine analoge Anordnung der Einzelprofile vorliegen, wobei diese dann konzentrisch relativ zueinander angeordnet sind. Es besteht allerdings auch die Möglichkeit, dass die Oberflächenprofilierungen nur aus einem spiralförmigen Einzelprofil bei Gehäusen 1 mit kreisförmigen Querschnitt gebildet ist.

Nach Fig. 5 ist insbesondere erkennbar, dass die Oberflächenprofilierungen 7, 8 durch Riffelung, Zacken, Zähne oder dergleichen gebildet sind, die von den übrigen Fügeflächen 4, 5 vorstehen oder auch in diesen versenkt angeordnet sind. Beispielsweise ist bei dem Gehäuseteil 2 die entsprechende Oberflächenprofilierung 7 durch versenkt angeordnete Profilsenken 16 gebildet, zwischen denen sich jeweils flächenbündig zur übrigen Fügefläche endende Profilspitzen 15 erstrecken.

In dem anderen Gehäuseteil 3 ist die Oberflächenprofilierung 8 durch über die übrige Fügefläche 5 vorstehende Profilspitzen 15 gebildet, zwischen denen sich bis zur übrigen Fügefläche 5 erstreckende Profilsenken 16 befinden.

Bei dem Ausführungsbeispiel nach Fig. 5 ist eine entsprechende Profiltiefe 13 bzw. Profilhöhe 14 der Profilsenken 16 bzw. Profilspitzen 15 gleich bei allen Einzelprofilen sowohl in Richtung senkrecht zur Gehäuselängsrichtung 18 als auch in Profilrichtung 12. Es besteht allerdings auch die Möglichkeit, bei einem weiteren Ausführungsbeispiel die Profiltiefe und/oder Profilhöhe in beiden Richtungen zu variieren.

Um einen guten Eingriff der entsprechenden Oberflächenprofilierungen 7, 8 mit reproduzierbaren Spaltabmessungen des Spaltes 6 zu erhalten und gleichzeitig die Herstellung der Oberflächenprofilierungen 7, 8 zu vereinfachen, können diese in den Gehäuseteilen 2 und 3 komplementär zueinander ausgebildet sein. Dies liegt beispielsweise bei dem Ausführungsbeispiel nach Fig. 5 vor.

Es sei noch angemerkt, dass es ebenfalls denkbar ist, dass die entsprechenden Fügeflächen 4, 5 bzw. Flanschflächen 9, 10 nicht senkrecht zur Gehäuselängsrichtung 18 angeordnet sind, sondern unter einem anderen Winkel geneigt zu dieser Längsrichtung verlaufen. Beispielsweise kann die Flanschfläche 9 mit entsprechender Fügefläche 4 und Oberflächenprofilierung 7 in Fig. 5 schräg nach oben verlaufen, wobei beispielsweise ein Winkel von 60° zwischen Gehäuselängsrichtung 18 und Flanschfläche 9 vorliegt. Analog kann die Flanschfläche 10 mit Fügefläche 5 und Oberflächenprofilierung 8 des Gehäuseteils 3 unter einem Winkel von 120° relativ zur Gehäuselängsrichtung 18 des Gehäuseteils 3 schräg nach oben verlaufen. Auch in diesem Fall sind die entsprechenden Oberflächenprofilierungen 7, 8 unter Bildung eines entsprechenden zünd-durchschlagsicheren Spaltes 6 miteinander in Eingriff.

Es ist selbstverständlich, dass weitere Neigungen von Flanschflächen 9, 10 relativ zu den entsprechenden Gehäuseteilen möglich sind.

Die erfindungsgemäße Oberflächenprofilierung dient nicht nur zur Bildung des entsprechenden Spaltes 6, sondern dient gleichzeitig auch zur Ausrichtung und Zentrierung der entsprechenden Gehäuseteile relativ zueinander. Dadurch vereint die erfindungsgemäße Oberflächenprofilierung Vorteile von verschiedenen bisher bekannten Fügeflächen für Gehäuseteile und weist darüber hinaus noch weitere Vorteile auf.

Es sei noch angemerkt, dass beispielsweise bei dem Ausführungsbeispiel nach Fig. 4 nicht die Notwendigkeit besteht, dass die entsprechenden Einzelprofile in den Ecken des Gehäuses aufeinander treffen und ineinander übergehen. In diesen Bereichen können auch entsprechende flache Flanschflächen, siehe Fig. 3, vorhanden sein. Dies würde beispielsweise die lösbare Befestigung der Gehäuseteile 2 und 3 mittels Befestigungsmitteln 17 in diesen Bereichen vereinfachen. Die Befestigungsmittel 17 sind dabei im Bereich der Fügeflächen 4, 5, aber außerhalb der Oberflächenprofilierungen 7, 8 angeordnet.

Es ist weiterhin denkbar, dass das erfindungsgemäße Gehäuse neben der Oberflächenprofilierung 7, 8 nach Fig. 4 und 5 eine zusätzliche schraubförmige Verbindung der Gehäuseteile 2 und 3 aufweist, wenn diese insbesondere nach Fig. 1 mit kreisförmigem Querschnitt ausgebildet sind. Eine solche schraubförmige Verbindung kann im Bereich von ineinander gesteckten und relativ zueinander verdrehbaren Teilen der Gehäuseteile 2 und 3 ausgebildet sein.

## Patentansprüche

1. Gehäuse (1) für ein elektrisches Betriebsmittel mit wenigstens einem ersten und einem zweiten Gehäuseteil (2, 3), die miteinander explosionsgeschützt zusammensetzbar sind, wobei jedes Gehäuseteil (2, 3) eine Fügefläche (4, 5) aufweist, die bei zusammengesetzten Gehäuseteilen (2, 3) miteinander unter Bildung eines zünddurchschlagsicheren Spalts (6) in Anlage sind, wobei weiterhin die Fügeflächen (4, 5) relativ zu den an diese angrenzenden Bereichen der Gehäuseteile (2, 3) im Wesentlichen senkrecht verlaufen und in diesen Oberflächenprofilierungen (7, 3) ausgebildet sind, zwischen denen der zünddurchschlagsichere Spalt (6) gebildet ist, **dadurch gekennzeichnet,**
**dass** die Fügeflächen (4, 5) als Teil einer radial nach außen vom jeweiligen Gehäuseteil (2, 3) abstehenden Flanschfläche (9, 10) ausgebildet sind und die Oberflächenprofilierungen (7, 8) in Profilrichtung (2) in Form einer Riffelung und spiralförmig ausgebildet sind.

2. Gehäuse nach Anspruch 1, **dadurch gekennzeichnet, dass** die Fügefläche (4, 5) umlaufend um das zugehörige Gehäuseteil (2, 3) ausgebildet ist.

3. Gehäuse nach Anspruch 1 oder 2, **dadurch gekennzeichnet, dass** das Gehäuseteil (2, 3) einen kreisförmigen oder eckigen Querschnitt aufweist.

4. Gehäuse nach einem der vorangehenden Ansprüche, **dadurch gekennzeichnet, dass** das Gehäuseteil (2, 3) zumindest im Bereich der Fügeflächen (4, 5) aus einem Metall und insbesondere Leichtmetall hergestellt ist.

5. Gehäuse nach einem der vorangehenden Ansprüche, **dadurch gekennzeichnet, dass** das Gehäuseteil (2, 3) zumindest im Bereich der Fügeflächen (4, 5) aus einem Kunststoffmaterial hergestellt ist.

6. Gehäuse nach Anspruch 5, **dadurch gekennzeichnet, dass** das Gehäuseteil wenigstens eine Beschichtung aus einem Kunststoffmaterial aufweist.

7. Gehäuse nach einem der vorangehenden Ansprüche, **dadurch gekennzeichnet, dass** das Gehäuseteil (2, 3) mit Fügefläche (4, 5) aus einem Gussteil gebildet ist.

8. Gehäuse nach Anspruch 7, **dadurch gekennzeichnet, dass** die Oberflächenprofilierung (7, 8) gleichzeitig beim Gießen hergestellt ist.

9. Gehäuse nach einem der vorangehenden Ansprüche, **dadurch gekennzeichnet, dass** die Oberflächenprofilierung (7, 8) durch insbesondere spanende Bearbeitung der Fügefläche (4, 5) hergestellt ist.

10. Gehäuse nach einem der vorangehenden Ansprüche, **dadurch gekennzeichnet, dass** die Oberflächenprofilierung (7, 8) in Profilrichtung (12) aus im Wesentlichen kreisförmigen oder eckigen Einzelprofilen (11) zusammengesetzt ist.

11. Gehäuse nach einem der vorangehenden Ansprüche, **dadurch gekennzeichnet, dass** die Oberflächenprofilierung (7, 8) in Profilrichtung (12) und/oder senkrecht zu dieser mit gleicher Profiltiefe (13) und/oder Profilhöhe (14) ausgebildet ist.

12. Gehäuse nach einem der vorangehenden Ansprüche, **dadurch gekennzeichnet, dass** die Gehäuseteile (2, 3) im Bereich der Fügeflächen (4, 5) und insbesondere außerhalb der Oberflächenprofilierungen (7, 8) miteinander lösbar verbunden sind.

13. Gehäuse nach einem der vorangehenden Ansprüche, **dadurch gekennzeichnet, dass** die Oberflächenprofilierung (7, 8) vorstehend oder versenkt in der Fügefläche ausgebildet ist.

## Claims

1. Housing (1) for an electrical component with at least a first and a second housing part (2, 3), which can be assembled together in an explosion-proof manner, wherein each housing part (2, 3) has a joining surface (4, 5) which, when the housing parts (2, 3) are assembled, engage with one another to form a flameproof gap (6), wherein furthermore the joining surfaces (4, 5) extend substantially perpendicular relative to the regions of the housing parts (2, 3) adjoining them and surface profilings (7, 3) are formed in them, between which the flameproof gap (6) is formed,
**characterised in that**
the joining surfaces (4, 5) are formed as part of a flange surface (9, 10) projecting radially outward from the respective housing part (2, 3), and the surface profilings (7, 8) are formed in the form of a corrugation and are spiral shaped in the profile direction (2).

2. Housing according to claim 1, **characterised in that** the joining surface (4, 5) is formed circumferentially around the associated housing part (2, 3).

3. Housing according to claim 1 or 2, **characterised in that** the housing part (2, 3) has a circular or angular cross-section.

4. Housing according to any one of the preceding claims, **characterised in that** the housing part (2, 3), at least in the region of the joining surfaces (4, 5), is made of a metal and in particular light metal.

5. Housing according to any one of the preceding claims, **characterised in that** the housing part (2, 3) is made of a plastic material at least in the region of the joining surfaces (4, 5).

6. Housing according to claim 5, **characterised in that** the housing part has at least one coating made of a plastic material.

7. Housing according to any one of the preceding claims, **characterised in that** the housing part (2, 3) having a joining surface (4, 5) is formed from a cast part.

8. Housing according to claim 7, **characterised in that** the surface profiling (7, 8) is produced simultaneously during casting.

9. Housing according to any one of the preceding claims, **characterised in that** the surface profiling (7, 8) is produced in particular by machining the joining surface (4, 5).

10. Housing according to any one of the preceding claims, **characterised in that** the surface profiling (7, 8) is composed of substantially circular or angular individual profiles (11) in the profile direction (12).

11. Housing according to any one of the preceding claims, **characterised in that** the surface profiling (7, 8) is formed with the same profile depth (13) and/or profile height (14) in the profile direction (12) and/or perpendicular to this.

12. Housing according to any one of the preceding claims, **characterised in that** the housing parts (2, 3) in the region of the joining surfaces (4, 5) and in particular outside the surface profilings (7, 8) are detachably connected together.

13. Housing according to any one of the preceding claims, **characterised in that** the surface profiling (7, 8) is formed projecting or recessed in the joining surface.

## Revendications

1. Boîtier (1) pour un équipement de fonctionnement électrique avec au moins une première et une deuxième partie de boîtier (2, 3), qui peuvent être assemblées entre elles avec une protection anti-explosion, dans lequel chaque partie de boîtier (2, 3) présente une face de jonction (4, 5), qui sont en appui, lorsque les parties de boîtier (2, 3) sont assemblées, les unes avec les autres en formant une fente (6) résistante à une déflagration, dans lequel par ailleurs les faces de jonction (4, 5) s'étendent de manière sensiblement perpendiculaire par rapport aux zones jouxtant celles-ci des parties de boîtier (2, 3) et sont réalisées dans lesdits profilages de surface (7, 3), entre lesquels la fente (6) résistante à une déflagration est formée,
**caractérisé en ce**
**que** les faces de jonction (4, 5) sont réalisées sous la forme d'une face de bride (9, 10) dépassant radialement vers l'extérieur depuis la partie de boîtier (2, 3) respective et les profilages de surface (7, 8) sont réalisés dans la direction de profil (2) sous la forme d'une cannelure et de manière à présenter une forme de spirale.

2. Boîtier selon la revendication 1, **caractérisé en ce que** la face de jonction (4, 5) est réalisée en périphérie autour de la partie de boîtier (2, 3) associée.

3. Boîtier selon la revendication 1 ou 2, **caractérisé en ce que** la partie de boîtier (2, 3) présente une section transversale de forme circulaire ou angulaire.

4. Boîtier selon l'une quelconque des revendications précédentes, **caractérisé en ce que** la partie de boîtier (2, 3) est fabriquée au moins dans la zone des faces de jonction (4, 5) à partir d'un métal et en particulier de métal léger.

5. Boîtier selon l'une quelconque des revendications précédentes, **caractérisé en ce que** la partie de boîtier (2, 3) est fabriquée au moins dans la zone des faces de jonction (4, 5) à partir d'un matériau en matière synthétique.

6. Boîtier selon la revendication 5, **caractérisé en ce que** la partie de boîtier présente au moins un revêtement composé d'une matière plastique.

7. Boîtier selon l'une quelconque des revendications précédentes, **caractérisé en ce que** la partie de boîtier (2, 3) est formée avec la face de jonction (4, 5) à partir d'une pièce coulée.

8. Boîtier selon la revendication 7,
**caractérisé en ce que** le profilage de surface (7, 8) est fabriqué de manière simultanée lors de la coulée.

9. Boîtier selon l'une quelconque des revendications, **caractérisé en ce que** le profilage de surface (7, 8) est fabriqué par un usinage en particulier par enlèvement de copeaux de la face de jonction (4, 5).

10. Boîtier selon l'une quelconque des revendications précédentes, **caractérisé en ce que** le profilage de surface (7, 8) est composé dans la direction de profil (12) de profils individuels (11) sensiblement de forme circulaire ou angulaires.

11. Boîtier selon l'une quelconque des revendications précédentes, **caractérisé en ce que** le profilage de surface (7, 8) est réalisé dans la direction de profil (12) et/ou de manière perpendiculaire par rapport à celle-ci avec une profondeur de profil (13) et/ou une hauteur de profil (14) identique.

12. Boîtier selon l'une quelconque des revendications précédentes, **caractérisé en ce que** les parties de boîtier (2, 3) sont reliées entre elles de manière amovible dans la zone des faces de jonction (4, 5) et en particulier à l'extérieur des profilages de surface (7, 8).

13. Boîtier selon l'une quelconque des revendications précédentes, **caractérisé en ce que** le profilage de surface (7, 8) est réalisé de manière saillante ou de manière enfoncée dans la face de jonction.
